# EUROPÄISCHE PATENTSCHRIFT

(11) **EP 4 221 476 B1**
(45) Veröffentlichungstag und Bekanntmachung des Hinweises auf die Patenterteilung: **24.04.2024**
(21) Anmeldenummer: 22153629.5
(22) Anmeldetag: 27.01.2022
(51) Int. Cl.: H05K 7/20

(54) **STROMLEITUNGSROHR UND STROMRICHTERANORDNUNG MIT EINEM SOLCHEN**
POWER LINE TUBE AND POWER CONVERTER ASSEMBLY USING THE SAME
TUBE DE FIL DE COURANT ET AGENCEMENT DE CONVERTISSEUR DOTÉ D'UN TEL TUBE

(43) Veröffentlichungstag der Anmeldung: 02.08.2023
(73) Patentinhaber: Siemens Energy Global GmbH & Co. KG, 81739 München (DE); Innomotics GmbH, 90441 Nürnberg (DE)
(72) Erfinder: Loges, Guido, 61239 Ober-Mörlen (DE); Reimann, Oliver, 91056 Erlangen (DE); Reimers, Timm, 21423 Drage (DE); Voss, Wolfgang, 91097 Oberreichenbach (DE); Wietoska, Jens, 28279 Bremen (DE)

(56) Entgegenhaltungen:
- EP-A1- 2 983 261
- DE-A1- 10 109 722
- US-A1- 2014 153 189
- US-A1- 2017 142 860

## Beschreibung

Stromleitungsrohr und Stromrichteranordnung mit einem solchen Die Erfindung betrifft ein Stromleitungsrohr zur Verwendung in einer Stromrichteranordnung, wobei das Stromleitungsrohr zur elektrischen Verbindung zwischen einem Gleichspannungsnetz und einer Anzahl an Stromrichtern vorgesehen ist.

Eine üblich eingesetzte Stromrichteranordnung umfasst in der Regel mehrere Stromrichter, welche gemeinsam mit der Gleichspannungsseite an ein Gleichspannungsnetz angeschlossen sind. Dabei werden die Stromrichter nebeneinander aufgestellt, so dass diese alle über eine kurze Leitungsstrecke miteinander verbunden werden können. Dabei werden grundsätzlich Hauptstromschienen aus einem sehr gut leitenden Material, d.h. Kupfer, eingesetzt, welche auf einer Seite an den Stromrichtern entlang geführt werden. Von diesen Hauptstromschienen erfolgt dann der Anschluss mit kurzen Anschlussschienen an die Stromrichter. Aus der DE 101 09 722 A1 ist ein Stromleitungsrohr gemäß dem Stand der Technik bekannt.

Der offensichtliche Vorteil dieser Anordnung ist die einfache Gestaltung und der geringe elektrische Widerstand und somit geringe Verlust durch die Anschlussanordnung.

Als Nachteil bei aktuellen Stromrichtern zeigt sich jedoch mitunter das Problem bei derartiger paralleler Aufstellung, dass die von den Stromrichtern systembedingt erzeugten Pulsungen eine Anregung in der Anschlussanordnung erzeugen können. Dieses wiederum belastet die gesamte Stromrichteranordnung in unerwünschter Weise.

Zur Vermeidung schädlicher Pulsungen werden häufig Zwischenkreiskondensatoren zur Dämpfung oder Entkopplungsdrosseln zur Filterung der unerwünschten Frequenzen eingesetzt.

Derartige Lösungen wiederum verursachen jedoch im Gegenzug wiederum unerwünschte Leistungsverluste in der Stromrichteranordnung.

Aufgabe der vorliegenden Erfindung ist es daher, Alternativen zu den üblichen Maßnahmen zur Reduzierung der Pulsungen bereitzustellen, welche geringere Leistungsverluste aufweisen.

Die gestellte Aufgabe wird durch eine erfindungsgemäße Ausführung eines Stromleitungsrohres nach der Lehre des Anspruchs 1 gelöst. Eine erfindungsgemäße Stromrichteranordnung ist im Anspruch 7 angegeben. Vorteilhafte Ausführungen sind Gegenstand der Unteransprüche.

Im Gegensatz zur gattungsgemäßen Form mit einer Hauptstromschiene aus einem sehr gut leitenden Material wird erfindungsgemäß ein Stromleitungsrohr aus einem Material mit einem höheren Widerstand eingesetzt. Das Stromleitungsrohr umfasst hierbei einen Leitungsabschnitt, zumindest zwei Kühlmittelanschlüsse und zumindest zwei Stromanschlüsse.

Die Stromanschlüsse sind mit dem Leitungsabschnitt elektrisch leitend verbunden und beanstandet zueinander angeordnet, sodass über die Stromanschlüsse der Stromkreis über den Leitungsabschnitt hergestellt werden kann. Die Stromanschlüsse können hierbei sowohl am Leitungsabschnitt montiert sein als auch mit dem Leitungsabschnitt beispielsweise über eine Lötverbindung fest verbunden sein. Dabei können die Stromanschlüsse sowohl an einem Ende oder beiden Enden des Leitungsabschnitt als auch im Verlauf des Leitungsabschnitts angeordnet sein.

Der Leitungsabschnitt ist hierbei in Form eines Rohres ausgebildet (wobei es unerheblich ist, ob dieser rund oder eckig oder einen sonstigen Querschnitt aufweist) und ermöglicht die Führung eines Kühlmittels. Um welche Art von Kühlmittel es sich hierbei handelt, ist zunächst unerheblich und insofern kann es sich sowohl um eine Flüssigkeit als auch um Gase handeln. Hierzu sind die Kühlmittelanschlüsse beabstandet zueinander angeordnet, wobei diese sowohl am Ende des Leitungsabschnitts als auch im Verlauf des Leitungsabschnitts angeordnet sein können. Zumindest ermöglichen diese die Zufuhr bzw. Abfuhr des Kühlmittels in bzw. aus dem Leitungsabschnitt.

Die Führung des Kühlmittels durch den Leitungsabschnitt, welcher zugleich als Stromleiter dient, ermöglicht einerseits die Zufuhr des Kühlmittels zu einem anderen Ort als auch insbesondere zugleich die Kühlung des Leitungsabschnitts selbst erfolgt. Hierzu ist weiterhin vorgesehen, dass bei zumindest zwei Stromanschlüssen jeweils ein Kühlmittelanschluss benachbart hierzu angeordnet ist. Dabei ist es nicht erforderlich, dass diese unmittelbar nebeneinander am Leitungsabschnitt angeordnet sind. Vielmehr soll eine Zufuhr bzw. Abfuhr des Kühlmittels in räumlicher Nähe zu einer Verbindung mit einem Stromanschluss ermöglicht werden.

Wesentliches Merkmal für die Erfindung ist dabei, dass das Material, aus dem der Leitungsabschnitt besteht, einen elektrischen Widerstand von zumindest 0,075 µΩm aufweist.

Als vorteilhaft hat es sich erwiesen, wenn das zur Herstellung des Leitungsabschnitts verwendete Material einen spezifischen elektrischen Widerstand von zumindest 0,25 µΩm aufweist. Besonders vorteilhaft ist dabei ein spezifischer elektrischer Widerstand von zumindest 0,5 µΩm.

Es ist naheliegend, dass die Leitungsverluste mit zunehmendem spezifischem Widerstand des eingesetzten Materials (bei angenommenem gleichbleibendem Querschnitt) größer werden. Entsprechend sollte der elektrische Widerstand nicht größer als 2 µΩm, besonders vorteilhaft nicht größer als 1 µΩm sein.

Da der zu übertragende Strom über die Stromanschlüsse geleitet werden muss und diese jedoch schlechter durch ein durch den Leitungsabschnitt strömendes Kühlmittel gekühlt werden können, ist es demgegenüber vorteilhaft, wenn die Stromanschlüsse aus einem abweichenden Material hergestellt sind und dieses einen spezifischen elektrischen Widerstand von maximal 0,05 µΩm aufweist. Besonders vorteilhaft ist die Verwendung eines Materials mit einem elektrischen Widerstand von maximal 0,025 µΩm. Somit kann eine übermäßige Wärmeentwicklung im Stromanschluss vermieden werden.

Bei Vorhandensein eines Hauptanschlusses, insbesondere zur Verbindung mit einem Stromnetz, und zumindest zwei oder mehr Abzweigungen, beispielsweise zu jeweils Stromrichtern, ist naheliegend der Hauptanschluss elektrisch stärker belastet. Insofern ist es besonders vorteilhaft, wenn zumindest der Hauptanschluss aus einem Material, beispielsweise Kupfer, hergestellt ist, welches einen besonders kleinen elektrischen Widerstand aufweist.

Besonders vorteilhaft ist eine Verwendung des Stromleitungsrohres, wenn dieses zur Führung einer Gleichspannung eingesetzt wird.

Die Ausführung und Anordnung der zueinander beanstandeten Stromanschlüsse sind zunächst unerheblich. Besonders vorteilhaft ist es jedoch, wenn an einem Ende des Leitungsabschnitt ein Hauptanschluss als Stromanschluss angeordnet ist. Dieses ermöglicht sowohl eine vorteilhafte Nutzung der Länge des Leitungsabschnitts als auch die Realisierung des Hauptanschlusses einfacher gestaltet.

Da der Leitungsabschnitt bestimmungsgemäß zur Führung eines Kühlmittels vorgesehen ist, ist es weiterhin vorteilhaft, wenn an zumindest einem Ende des Leitungsabschnitts ein Versorgungsanschluss als Kühlmittelanschluss vorhanden ist. Dieses ermöglicht einerseits die Kühlung des Leitungsabschnitts bis zu diesem Ende sowie ebenso eine einfache Anordnung des Versorgungsanschlusses an einem Abschlusselement möglich ist.

Dabei kann vorgesehen sein, dass der vorteilhafte Hauptanschluss am gegenüberliegenden Ende des vorteilhaften Versorgungsanschlusses angeordnet ist. Demgegenüber kann auch vorgesehen sein, dass der Hauptanschluss und der Versorgungsanschluss am gleichen Ende angeordnet sind. Zur optimalen Durchspülung des Leitungsabschnitts ist es besonders vorteilhaft, wenn an beiden Enden jeweils ein Versorgungsanschluss angeordnet ist.

Weiterhin ist es besonders vorteilhaft, wenn das Stromleitungsrohr mit einem Stromrichter verbunden wird. Dabei kann vorgesehen sein, dass der Anschluss über einen an einem Ende angeordneten Hauptanschluss erfolgt. Vorteilhaft ist jedoch, wenn der Anschluss eines Stromrichters an einem beanstandet zu den Enden angeordneten Stromanschluss erfolgen kann.

Besonders vorteilhaft gestaltet sich die Verwendung des Stromleitungsrohres, wenn zugleich zwei Stromrichter angeschlossen werden können. Hierzu sind vorzugsweise zwei Stromanschlüsse beanstandet zu den Enden am Leitungsabschnitt anzuordnen.

Weiterhin ist vorteilhaft, wenn beispielsweise ein Stromrichter mit einer Kühlflüssigkeit über das Stromleitungsrohr versorgt werden kann. Hierzu ist vorteilhaft der Kühlmittelanschluss benachbart zum Stromanschluss anzuordnen. Mit einer Anordnung eines Stromanschlusses, besonders vorteilhaft zweier Stromanschlüsse, im Verlauf des Leitungsabschnitts ist entsprechend auch vorteilhaft zumindest ein Kühlmittelanschluss, besonders vorteilhaft zwei Kühlmittelanschlüsse, beanstandet zu den Enden des Leitungsabschnitts an diesem anzuordnen.

In Abhängigkeit von der Länge des Stromleitungsrohres, dessen Befestigung sowie der Anbringung von Kühlmittelleitungen und/oder Stromleitungen, kann es vorteilhaft sein, wenn ein Dehnungsausgleich ermöglicht wird. Hierzu umfasst das Stromleitungsrohr einen ersten Leitungsabschnitt und zumindest einen zweiten Leitungsabschnitt, wobei die Leitungsabschnitte über einen Dehnungsausgleich miteinander verbunden sind.

Dabei kann in einer ersten Ausführungsform vorgesehen sein, dass der Dehnungsausgleich quasi mit einem Bauteil zugleich eine Führung des Kühlmittels von einem Leitungsabschnitt in den anderen Leitungsabschnitt als auch die Stromführung ermöglicht. Hierzu kann der Dehnungsausgleich beispielsweise in Form eines elektrisch leitenden und Kühlmittel-führenden Faltenbalgs ausgeführt sein. Alternativ ist es möglich, einen Rohrverlauf vorzusehen, welcher U-förmig oder Mäander-förmig die beiden Enden der Leitungsabschnitte miteinander verbindet.

In einer besonders vorteilhaften zweiten Ausführungsform umfasst der Dehnungsausgleich zwischen den beiden gegenüberliegenden Enden der Leitungsabschnitte einen Kühlmittel-führenden Faltenbalg oder Kompensator. Dabei ist eine elektrische Leitfähigkeit des Faltenbalges oder des Kompensators nicht notwendig. Hierzu ist vorgesehen, dass die beiden Enden der Leitungsabschnitte über eine elektrisch leitende Brücke, den Faltenbalg bzw. Kompensator umgehend, miteinander verbunden sind. Somit kann der Faltenbalg bzw. Kompensator beispielsweise ein Kunststoffmaterial oder ein gummiartiges Material umfassen, während hingegen die Brücke aus einem vorzugsweise sehr gut leitenden Material hergestellt ist.

Bestimmungsgemäß ist vorgesehen, dass die Kühlmittelführung über die Kühlmittelanschlüsse, hingegen die Stromführung über die Stromanschlüsse erfolgt. Um eine Stromführung über den Kühlmittelanschluss zu verhindern kann vorgesehen sein, dass der Kühlmittelanschluss zumindest teilweise, insbesondere in den Kontaktflächen, aus einem nicht-leitenden Material besteht.

Sofern an einem Ende des Leitungsabschnitts kein Versorgungsanschluss stirnseitig angeordnet ist, so weist vorteilhaft das Stromleitungsrohr an diesem Ende ein Abschlusselement zum Verschließen des Leitungsabschnitts auf. Insbesondere bei Anordnung eines Hauptanschlusses an diesem Ende ist es weiterhin vorteilhaft, wenn das Abschlusselement zugleich den Hauptanschluss bildet.

Das erfindungsgemäße Stromleitungsrohr, wie zuvor beschrieben, ermöglicht die Realisierung einer erfindungsgemäßen Stromrichteranordnung. Dabei umfasst die Stromrichteranordnung ein erstes Stromleitungsrohr und ein zweites, vom ersten Stromleitungsrohr getrenntes Stromleitungsrohr, ausgeführt entsprechend vorhergehender Beschreibung. Weiterhin umfasst die Stromrichteranordnung zumindest einen Stromrichter. Dabei ist vorgesehen, dass der Stromrichter jeweils über zumindest eine elektrisch leitende Stromschiene mit einem jeweiligen Stromanschluss des ersten bzw. des zweiten Stromleitungsrohres verbunden ist. Weiterhin ist vorgesehen, dass der Stromrichter zugleich jeweils über ein nicht-leitendes Kühlmittelrohr mit einem jeweiligen Kühlmittelanschluss des ersten bzw. des zweiten Stromleitungsrohres verbunden ist. Somit kann der Stromrichter über die Stromleitungsrohre in das Stromnetz eingebunden werden und zugleich mit Kühlmittel versorgt werden.

Vorteilhaft eignet sich die Verwendung der erfindungsgemäßen Stromleitungsrohre, wenn die Stromrichteranordnung zumindest zwei, besonders vorteilhaft zumindest drei, Stromrichter aufweist, welche gemeinsam an den beiden Stromleitungsrohren angeschlossen sind. Naheliegend bedarf es somit einer entsprechenden Anzahl an Stromanschlüssen und Kühlmittelanschlüssen an dem jeweiligen Stromleitungsrohr.

Dabei erfolgt in bevorzugter Weise der Anschluss des Stromrichters derart, dass dieser mit einer Gleichspannungsseite mit den Stromleitungsrohren verbunden ist und insofern die Stromleitungsrohre zur Führung von Gleichspannung Verwendung finden.

In einer weiteren vorteilhaften Ausführung wird zur Bildung der Stromrichteranordnung eine Kühlmittelversorgung bereitgestellt, welche über ein erstes nicht-leitendes Anschlussrohr am ersten Versorgungsanschluss des ersten Stromleitungsrohres und über ein zweites nicht-leitendes Anschlussrohr am zweiten Versorgungsanschluss des zweiten Stromleitungsrohres angeschlossen ist. Hierdurch wird eine Versorgung mit Kühlmittel sowie eine Zirkulation des Kühlmittels ermöglicht.

Hierzu weist in vorteilhafter Weise die Kühlmittelversorgung zumindest eine Kühlmittelpumpe sowie zumindest eine Kühleinrichtung auf. Hierdurch wird die Zirkulation des Kühlmittels unterstützt sowie eine entsprechend gewünschte niedrige Temperatur des Kühlmittels bereitgestellt.

Um ein Totvolumen in einem Stromleitungsrohr zu vermeiden, sofern am Ende des Stromleitungsrohres gegenüberliegend zum Anschluss an die Kühlmittelversorgung kein unmittelbarer Anschluss an beispielsweise einem Stromrichter erfolgt, ist es vorteilhaft, wenn die Stromleitungsrohre am Ende gegenüberliegend zum Anschluss an die Kühlmittelversorgung jeweils Versorgungsanschlüsse aufweisen, welche miteinander über ein nicht-leitendes Verbindungsrohr, beispielsweise mit geringem Querschnitt, miteinander verbunden sind und somit einen Kühlkreislauf durch das Verbindungsrohr ermöglichen.

Weiterhin kann vorgesehen sein, dass zur Verbesserung der Dämpfung bzw. Unterdrückung von Schwingungen ein Kondensator an den beiden Stromleitungsrohren über weitere Stromanschlüsse angeschlossen ist. Dabei sind jedoch keine benachbarten Kühlmittelschlüsse erforderlich.

Eine besonders vorteilhafte Stromrichteranordnung ist gegeben, wenn diese an ein Gleichspannungsnetz angeschlossen ist. Hierzu wird der jeweilige Hauptanschluss der beiden Stromleitungsrohre mit dem Gleichspannungsnetz verbunden. Dabei ist vorgesehen, dass am Gleichspannungsnetz elektrische Verbraucher (gleich welcher Art, beispielsweise Motor, Batterie, usw.) angeschlossen sind.

In den nachfolgenden Figuren ist eine erfindungsgemäße Stromrichteranordnung mit erfindungsgemäßen Stromleitungsrohren skizziert. Es zeigen:
- Fig. 1: ein Ausführungsbeispiel für eine beispielhafte Stromrichteranordnung mit drei Stromrichtern;
- Fig. 2: ein beispielhaftes Stromleitungsrohr zur Fig. 1;
- Fig. 3: einen Leitungsabschnitt, verwendet in dem Stromleitungsrohr aus Fig. 2;
- Fig. 4: einen Faltenbalg, verwendet in dem Stromleitungsrohr aus Fig. 2;
- Fig. 5: eine Brücke, verwendet in dem Stromleitungsrohr aus Fig. 2.

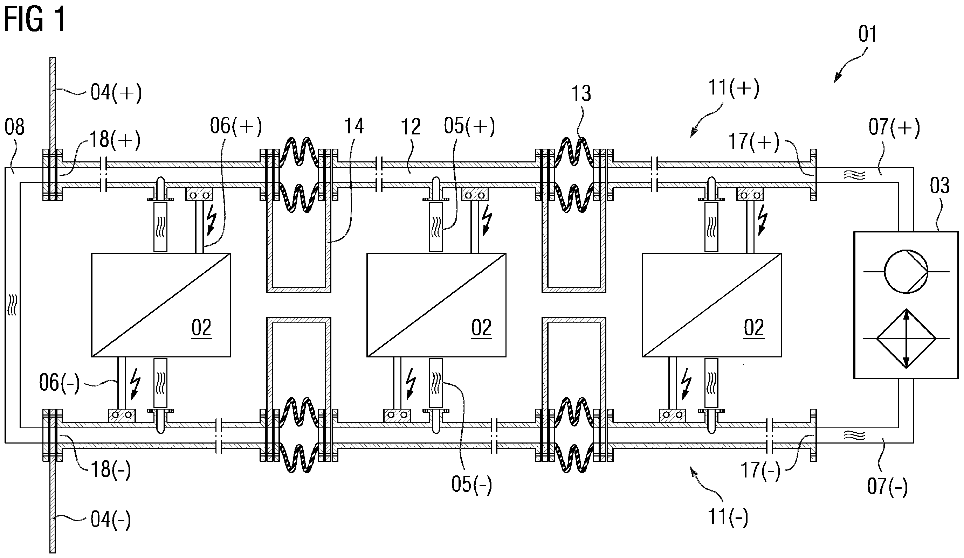

In der Fig. 1 wird schematisch eine beispielhafte Ausführungsform für eine erfindungsgemäße Stromrichteranordnung 01 skizziert. Diese umfasst als wesentliche Elemente zwei Stromleitungsrohre 11(+), 11(-). An diesen 11(+), 11(-) sind drei Stromrichter 02 angeschlossen. Dabei haben die Stromleitungsrohre 11(+), 11(-) zweierlei Aufgaben.

Der Hauptzweck besteht in der Stromleitung, hier jeweils von/zu einem Hauptanschluss 04(+), 04(-), welche 04 an einem jeweiligen Ende der Stromleitungsrohre 11 angeordnet sind, über die Leitungsabschnitte 12 zum jeweiligen Stromanschluss 16. Die Stromrichter 02 sind über Stromschienen 06(+), 06(-) mit den Stromanschlüssen 16 verbunden.

Zugleich erfüllt das jeweilige Stromleitungsrohr 11 die Aufgabe der Leitung eines Kühlmittels. Hierzu sind die Stromleitungsrohre 11 hohl ausgeführt. Dabei weisen die Stromleitungsrohre 11 an einem Ende (hier gegenüberliegend zum Hauptanschluss) einen Versorgungsanschluss 17(+), 17(-) auf, welche 17 über nicht-leitende Anschlussrohre 07(+), 07(-) mit einer Kühlmittelversorgung 03 verbunden sind. Im Verlauf der Leitungsabschnitte 12 sind Kühlmittelanschlüsse 15 angeordnet. Somit ist der Kühlmittelfluss von/zu der Kühlmittelversorgung 03 zu/von den Kühlmittelanschlüssen 15 ermöglicht. Die Kühlmittelversorgung 03 weist hierbei eine Kühlmittelpumpe zur Förderung des Kühlmittels und eine Kühleinrichtung zur Kühlung des Kühlmittels auf.

Wesentlich ist die Möglichkeit an die beiden Stromleitungsrohre 11 einen Stromrichter 02 anschließen zu können, und zwar an einen Stromanschluss und zugleich an einen Kühlmittelanschluss.

Um ein Totvolumen in den Stromleitungsrohren 11 zu vermeiden ist weiterhin vorgesehen, dass gegenüberliegend zu den Versorgungsanschlüssen 17 in Verbindung mit der Kühlmittelversorgung 03 weitere Versorgungsanschlüsse 18(+), 18(-) vorhanden sind. Hierbei sind die beiden weiteren Versorgungsanschlüsse 18 über ein nicht-leitendes Verbindungsrohr 08 miteinander verbunden. Da das Kühlmittel insbesondere zur Kühlung der Stromrichter 02 benötigt wird, kann ein relativ kleiner Querschnitt für das Verbindungsrohr gewählt werden.

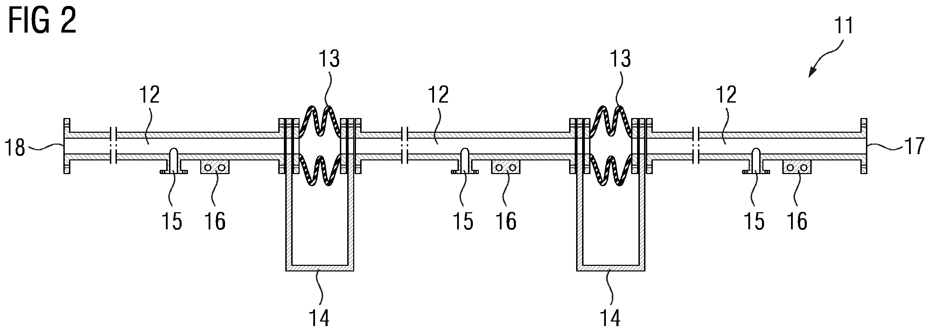

In der Fig. 2 ist ein Stromleitungsrohr 11, wie dieses 11 in der Stromleiteranordnung 01 aus Fig. 1 zweifach verwendet wird, skizziert. In diesem Ausführungsbeispiel umfasst das Stromleitungsrohr 11 drei Abschnitte mit jeweils einem Leitungsabschnitt 12, welcher 12 in Art eines Rohres ausgeführt ist.

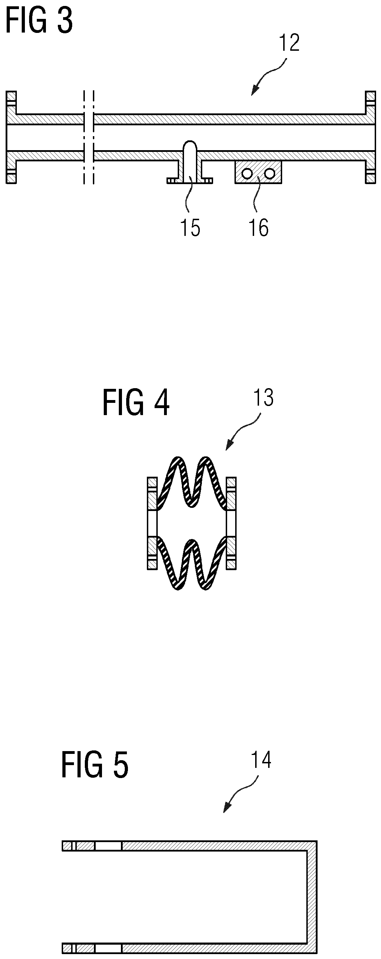

An jedem dieser drei Leitungsabschnitte 12, welche 12 nochmals in Fig. 3 skizziert werden, ist jeweils ein Kühlmittelanschluss 15 und benachbart ein Stromanschluss 16 angeordnet.

Die Verbindung zweier Leitungsabschnitte 12 erfolgt über einen Dehnungsausgleich, über den sowohl die Stromleitung als auch die Kühlmittelführung gewährleistet werden muss. Dazu hat der Dehnungsausgleich bestimmungsgemäß die Aufgabe kleine Längenänderungen, beispielsweise aufgrund thermischer Dehnungen der Leitungsabschnitte 12, zu ermöglichen.

In diesem Ausführungsbeispiel umfasst der Dehnungsausgleich einen Faltenbalg 13 - siehe Fig. 4, welcher 13 die Führung des Kühlmittels von einem Leitungsabschnitt 12 in den benachbarten Leitungsabschnitt 12 ermöglicht.

Da hier nicht gefordert wird, dass der Faltenbalg 13 elektrisch leitend ist, sind die beiden gegenüberliegenden Enden der Leitungsabschnitte 12 über eine Brücke 14 - siehe Fig. 5 - miteinander verbunden. Die Brücke 14 dient hier zur Stromführung und sollte dabei einen besonders geringen Widerstand aufweisen. Dabei weist die Brücke 14 eine U-Form und somit ebenso eine gewisse Elastizität auf.

## Patentansprüche

1. Stromleitungsrohr (11) mit zumindest einem Leitungsabschnitt (12), welcher (12) als Rohr zur Führung eines Kühlmittels ausgebildet ist und aus einem Material mit einem elektrischen Widerstand von zumindest 0,075 µΩm besteht, und mit zumindest zwei Kühlmittelanschlüssen (15, 17, 18), an denen (15, 17, 18) jeweils ein Kühlmittelrohr (05, 07, 08) angeschlossen werden kann, und mit zumindest zwei zueinander beabstandeten Stromanschlüssen (04, 16), welche (04, 16) jeweils mit dem Leitungsabschnitt (12) elektrisch leitend verbunden und benachbart zu einem Kühlmittelanschluss (15, 18) angeordnet sind und an denen (04, 16) jeweils eine Stromschiene (06) angeschlossen werden kann.

2. Stromleitungsrohr (11) nach Anspruch 1,
wobei der elektrische Widerstand des Materials des Leitungsabschnitts (12) zumindest 0,25 µΩm, insbesondere zumindest 0,5 µΩm, beträgt; und/oder
wobei der elektrische Widerstand des Materials der Stromanschlüsse (04, 16) maximal 0,05 µΩm, insbesondere maximal 0,025 µΩm, beträgt.

3. Stromleitungsrohr (11) nach Anspruch 1 oder 2,
umfassend an zumindest einem Ende einen Hauptanschluss (04) als Stromanschluss; und/oder
umfassend an zumindest einem Ende einen Versorgungsanschluss (17, 18) als Kühlmittelanschluss; und/oder
umfassend zumindest zwei zueinander und von den Enden beabstandete Stromanschlüsse (16) und zumindest zwei von den Enden beabstandete Kühlmittelanschlüsse (15).

4. Stromleitungsrohr (11) nach einem der Ansprüche 1 bis 3, umfassend einen ersten Leitungsabschnitt (12) und zumindest einen zweiten Leitungsabschnitt (12) und einem zwischen den Leitungsabschnitten (12) angeordneten Dehnungsausgleich.

5. Stromleitungsrohr nach Anspruch 4,
wobei der Dehnungsausgleich von einem elektrisch leitenden und Kühlmittel führenden Faltenbag oder U-förmigen oder Mäander-förmigen Rohrverlauf gebildet wird.

6. Stromleitungsrohr (11) nach Anspruch 4,
wobei der Dehnungsausgleich einen Kühlmittel-führenden Faltenbag (13) oder Kompensator und eine die angrenzenden Enden der Leitungsabschnitte (12) miteinander verbindende elektrisch leitende Brücke (14) umfasst.

7. Stromrichteranordnung (01) umfassend ein erstes Stromleitungsrohr (11+) und ein zweites Stromleitungsrohr (11-) jeweils ausgeführt nach einem der vorhergehenden Ansprüche und zumindest einen Stromrichter (02), welcher (02) über jeweils eine elektrisch leitende Stromschiene (06) mit den Stromanschlüssen (16) und über jeweils ein nicht-leitendes Kühlmittelrohr (05) mit den Kühlmittelanschlüssen (15) der beiden Stromleitungsrohre (11+, 11-) verbunden ist.

8. Stromrichteranordnung (01) nach Anspruch 7,
umfassend zumindest zwei, insbesondere zumindest drei, Stromrichter (02), welche (02) an den Stromleitungsrohren (11+, 11-) angeschlossen sind.

9. Stromrichteranordnung (01) nach Anspruch 7 oder 8, umfassend eine Kühlmittelversorgung (03), welche (03) mit einem ersten nicht-leitenden Anschlussrohr (07+) am ersten Versorgungsanschluss (17+) und mit einem zweiten nicht-leitenden Anschlussrohr (07-) am zweiten Versorgungsanschluss (17-) angeschlossen ist.

10. Stromrichteranordnung (01) nach Anspruch 9,
wobei die Kühlmittelversorgung (03) eine Kühlmittelpumpe und eine Kühleinrichtung aufweist.

11. Stromrichteranordnung (01) nach Anspruch 9 oder 10, umfassend ein nicht-leitendes Verbindungsrohr (08), welches (08) Kühlmittel-führend an Versorgungsanschlüssen (18+, 18-) gegenüberliegend zum Anschluss and die Kühlmittelversorgung (03) angeschlossen ist.

12. Stromrichteranordnung (01) nach einem der Ansprüche 7 bis 11,
umfassend zumindest einen Kondensator, welcher an weiteren Stromanschlüssen (16+, 16-) der beiden Stromleitungsrohre (11+, 11-) angeschlossen ist.

13. Stromrichteranordnung (01) nach einem der Ansprüche 7 bis 12,
umfassend ein Gleichspannungsnetz, welches an den Hauptanschlüssen (04+, 04-) angeschlossen ist und an dem wiederum elektrische Verbraucher angeschlossen sind.

## Claims

1. Power line pipe (11) having at least one line section (12), which line section (12) is in the form of a pipe for carrying a coolant and consists of a material with an electrical resistance of at least 0.075 µΩm, and having at least two coolant connections (15, 17, 18), to each of which coolant connections (15, 17, 18) a coolant pipe (05, 07, 08) can be connected, and having at least two power connections (04, 16), which power connections (04, 16) are spaced apart from each other and are each electrically conductively connected to the line section (12) and are arranged adjacent to a coolant connection (15, 18) and a busbar (06) being able to be connected to each power connection (04, 16).

2. Power line pipe (11) according to Claim 1,
wherein the electrical resistance of the material of the line section (12) is at least 0.25 µΩm, in particular at least 0.5 µΩm; and/or
wherein the electrical resistance of the material of the power connections (04, 16) is at most 0.05 µΩm, in particular at most 0.025 µΩm.

3. Power line pipe (11) according to Claim 1 or 2,
comprising a main connection (04) as a power connection at at least one end; and/or
comprising a supply connection (17, 18) as a coolant connection at at least one end; and/or
comprising at least two power connections (16), which are spaced apart from each other and from the ends, and at least two coolant connections (15), which are spaced apart from the ends.

4. Power line pipe (11) according to any of Claims 1 to 3, comprising a first line section (12) and at least a second line section (12) and an expansion-compensation means, which is arranged between the line sections (12).

5. Power line pipe according to Claim 4,
wherein the expansion-compensation means is formed by an electrically conductive and coolant-carrying folding bellows or U-shaped or meandering pipe profile.

6. Power line pipe (11) according to Claim 4,
wherein the expansion-compensation means comprises a coolant-carrying folding bellows (13) or compensator and an electrically conductive bridge (14), which connects the adjoining ends of the line sections (12) to each other.

7. Power converter arrangement (01) comprising a first power line pipe (11+) and a second power line pipe (11-), each designed according to any of the preceding claims, and at least one power converter (02), which power converter (02) is connected to the power connections (16) via an electrically conductive busbar (06) in each case and is connected to the coolant connections (15) of the two power line pipes (11+, 11-) via a non-conductive coolant pipe (05) in each case.

8. Power converter arrangement (01) according to Claim 7, comprising at least two, in particular at least three, power converters (02), which power converters (02) are connected to the power line pipes (11+, 11-).

9. Power converter arrangement (01) according to Claim 7 or 8,
comprising a coolant supply means (03), which coolant supply means (03) is connected by way of a first non-conductive connection pipe (07+) to the first supply connection (17+) and by way of a second non-conductive connection pipe (07-) to the second supply connection (17-).

10. Power converter arrangement (01) according to Claim 9, wherein the coolant supply means (03) has a coolant pump and a cooling device.

11. Power converter arrangement (01) according to Claim 9 or 10,
comprising a non-conductive connecting pipe (08), which connecting pipe (08) is connected in a coolant-carrying manner to supply connections (18+, 18-) opposite the connection to the coolant supply (03).

12. Power converter arrangement (01) according to any of Claims 7 to 11,
comprising at least one capacitor, which is connected to further power connections (16+, 16-) of the two power line pipes (11+, 11-) .

13. Power converter arrangement (01) according to any of Claims 7 to 12,
comprising a DC voltage network, which is connected to the main connections (04+, 04-) and to which electrical loads are connected in turn.

## Revendications

1. Tube (11) de fil de courant ayant au moins un tronçon (12) de fil, qui (12) est constitué en tube pour la conduite d'un réfrigérant et est en un matériau d'une résistance électrique d'au moins 0,075 µΩm, et comprenant au moins deux raccords (15, 17, 18) pour du réfrigérant, auxquels (15, 17, 18) peut être raccordé respectivement un tube (05, 07, 08) pour du réfrigérant, et comprenant au moins deux bornes (04, 16), de courant à distance l'une de l'autre, qui (04, 16) sont reliées d'une manière conductrice de l'électricité respectivement au tronçon (12) de fil et sont disposées en étant voisines d'un raccord (15, 18) pour du réfrigérant et auxquelles (04, 16) peut être connecté respectivement une barre (06) de courant.

2. Tube (11) de fil de courant suivant la revendication 1,
dans lequel la résistance électrique du matériau du tronçon (12) de fil est d'au moins 0,25 µΩm, en particulier d'au moins 0,5 µΩm ; et/ou,
dans lequel la résistance électrique du matériau des bornes (04, 16) de courant est au maximum de 0,05 µΩm, en particulier au maximum de 0,025 µΩm.

3. Tube (11) de fil de courant suivant la revendication 1 ou 2,
comprenant, à au moins un bout, une borne (04) principale comme borne de courant ; et/ou
comprenant, à au moins un bout, un raccord (17, 18) d'alimentation comme raccord pour du réfrigérant ; et/ou
comprenant au moins deux bornes (16) de courant à distance l'une de l'autre et des bouts et au moins deux raccords (15) pour du réfrigérant à distance des bouts.

4. Tube (11) de fil de courant suivant l'une des revendications 1 à 3,
comprenant un premier tronçon (12) de fil et au moins un deuxième tronçon (12) de fil et une compensation de dilatation entre les tronçons (12) de fil.

5. Tube de fil de courant suivant la revendication 4,
dans lequel la compensation de dilatation est formée par un soufflet à plis conducteur de l'électricité et conduisant du réfrigérant ou par un tracé du tube en forme de U ou de forme sinueuse.

6. Tube (11) de fil de courant suivant la revendication 4, dans lequel la compensation de dilatation comprend un soufflet (13) à plis conduisant du réfrigérant ou un compensateur et un pont (14) conducteur de l'électricité reliant entre eux les bouts voisins des tronçons (12) de fil.

7. Agencement (01) de convertisseur comprenant un premier tube (11+) de fil de courant et un deuxième tube (11-) de fil de courant réalisés chacun suivant l'une des revendications précédentes et au moins un convertisseur (02), qui (02) est connecté par respectivement une barre (06) de courant conductrice de l'électricité aux bornes (16) de courant et par respectivement un tube (05) non conducteur pour du réfrigérant aux raccords (15) pour du réfrigérant des deux tubes (11+, 11-) de fil de courant.

8. Agencement (01) de convertisseur suivant la revendication 7,
comprenant au moins deux, en particulier au moins trois, convertisseurs (02), qui (02) sont connectés aux tubes (11+, 11-) de fil de courant.

9. Agencement (01) de convertisseur suivant la revendication 7 ou 8,
comprenant une alimentation (03) en réfrigérant, qui (03) est raccordée à un premier tube (07+) non conducteur de raccordement au premier raccord (17+) d'alimentation et à un deuxième tube (07-) non conducteur de raccordement au deuxième raccord (17-) d'alimentation.

10. Agencement (01) de convertisseur suivant la revendication 9,
dans lequel l'alimentation (03) en réfrigérant comporte une pompe d'agent réfrigérant et un dispositif de refroidissement.

11. Agencement (01) de convertisseur suivant la revendication 9 ou 10,
comprenant un tube (08) non conducteur de liaison, qui (08) est raccordé à des raccords (18+, 18-) d'alimentation conduisant du réfrigérant en regard pour le raccordement et l'alimentation (03) en réfrigérant.

12. Agencement (01) de convertisseur suivant l'une des revendications 7 à 11,
comprenant au moins un condensateur, qui est raccordé à d'autres bornes (16+, 16-) de courant des deux tubes (11+, 11-) de fil de courant.

13. Agencement (01) de convertisseur suivant l'une des revendications 7 à 12, comprenant un réseau en tension continue, qui est connecté aux bornes (04+, 04-) principales et auquel sont connectés à leur tour des consommateurs électriques.
